# EUROPEAN PATENT APPLICATION

(11) **EP 4 700 835 A1**
(43) Date of publication of application: **25.02.2026**
(21) Application number: 24792999.5
(22) Date of filing: 17.04.2024
(51) Int. Cl.: H01L 33/58, H01L 33/48, H01L 33/62, H01L 33/64, F21K 9/65, F21K 9/69, F21K 9/238, F21V 29/508

(54) **LIGHT-EMITTING DEVICE AND LIGHTING APPARATUS COMPRISING SAME**

(30) Priority: 18.04.2023 US 202363496764 P; 15.04.2024 US 202418635247
(71) Applicant: Seoul Semiconductor Co., Ltd., Gyeonggi-do 15429 (KR)
(72) Inventor: KO, Miso, Ansan-Si Gyeonggi-do 15429 (KR); CHOI, Eunmi, Ansan-Si Gyeonggi-do 15429 (KR)
(74) Representative: Stolmár & Partner Patentanwälte PartG mbB
(86) International application number: PCT/KR2024/005150
(87) International publication number: WO 2024/219814

(57) **Abstract**

A light emitting device is provided for increasing light emission efficiency, and a vehicle lamp or lighting apparatus including the same. The light emitting device includes a light emitter, a light transmitter disposed on a first region corresponding to at least a portion of a top surface of the light emitter and configured to change a characteristic of light emitted from the light emitter, and a light extraction layer disposed on a top surface of the light transmitter. A refractive index of air corresponds to a first refractive index, a refractive index of the light transmitter corresponds to a second refractive index, and the light extraction layer has a third refractive index in a range between the first refractive index and the second refractive index.

## Description

### Technical Field

The following description relates to a light emitting device that increases light emission efficiency and a lighting apparatus using the same.

### Background Art

Light emitting diodes are inorganic semiconductor devices that emit light generated by recombination of electrons and holes, and have recently been used in various fields such as display devices, automobile lamps, and general lighting. Light emitting diodes have a long service-life, low power consumption, and fast response time, and accordingly light emitting devices including light emitting diodes are expected to replace conventional light sources.

When a light emitting device including the above-described light emitting diodes or another type of light emitting device is utilized as a lighting apparatus, superior light straightness is required compared to a light emitting device for general illumination.

In the case of a lighting apparatus requiring light straightness, such as the above-described automotive light emitting devices, when light emitted from a light emitter enters the air through the light transmitter, the difference in refractive index between the light transmitter and the air causes the light to be diffused, thus may reduce the efficiency of the light emitted forward.

Furthermore, the heat generated by the light emitting device may deteriorate the performance of the light emitting device.

### DISCLOSURE

### Technical Problem

Exemplary embodiments provide a light emitting device for improving the light extraction rate.

In one embodiment, proposed is a light emitting device having a light extraction layer further disposed on top of the light transmitter that is configured to sequentially change the refractive index to change the characteristics of the light emitted by the light emitter, and configured to minimize the total reflection as the light from the light emitting device ultimately enters the air.

Furthermore, a structure for efficiently arranging a heat dissipater in the light emitting device to increase heat dissipation efficiency is proposed.

In addition, a light emitting device which secures stability between components and improves light straightness is proposed by specifying the material of each component of the light emitting device.

The objects of the present disclosure are not limited to the above-mentioned technical objects, and other technical objects not mentioned will become apparent to one of ordinary skill in the art from the following description.

### Technical Solution

According to an embodiment of the present disclosure, provided is a light emitting device including a light emitter, a light transmitter disposed on a first region corresponding to at least a portion of a top surface of the light emitter and configured to change a characteristic of light emitted from the light emitter, and a light extraction layer disposed on a top surface of the light transmitter, wherein, a refractive index of air corresponds to a first refractive index, a refractive index of the light transmitter corresponds to a second refractive index, and the light extraction layer has a third refractive index in a range between the first refractive index and the second refractive index.

In other words, the third refractive index may be lower than the second refractive index.

Specifically, a difference between the third refractive index and the first refractive index may be set to be greater than a difference between the second refractive index and the third refractive index.

Specifically, a vertical thickness of the light extraction layer may be less than or equal to a vertical thickness of the light transmitter. As an example, the vertical thickness of the light extraction layer may be within a range from 0.05% to 5% of the vertical thickness of the light transmitter.

In the above example, "vertical thickness" may refer to the physical thickness. In another example, it may refer to the "length of the light path" rather than the physical thickness.

The light extraction layer may include at least one same element as the light transmitter.

The light emitting device may further include a substrate, and an electrode pattern disposed on the substrate. The light emitter may be disposed on the electrode pattern, but need not be limited to such a structure. A PCB or the like for controlling the light emitting device may be formed separately, as will be described later.

In the structure as described above, the light emitting device may further include a light path adjuster formed at a position surrounding the periphery of the light emitter and configured to correct a light path of the light emitter.

In this case, the light path adjuster may comprise regions of different heights.

Specifically, the light path adjuster may include a structure having a height that decreases outwardly from a top boundary of the light extraction layer.

Alternatively, the light path adjustment portion may include a structure having a height that decreases outwardly from the bottom boundary of the light extraction layer.

A corner of a first region from which light corresponding to the light emitter is emitted may be formed to include a first radius of curvature, and a corner of the light path adjuster may be formed to include a second radius of curvature.

In this case, the radius of curvature of the first region may be different from the radius of curvature of the light path adjuster.

Specifically, the radius of curvature of the first region may be less than the radius of curvature of the light path adjuster, wherein the substrate may include a first additive and the light path adjuster may include a second additive, wherein the first additive and the second additive may have different melting points.

In this case, the melting point of the first additive may be higher than the melting point of the second additive.

The light path adjuster may include a modified region having irregularities in a region vertically spaced apart from the light emitter. The irregularities may be optionally applied. In some cases, an element formed of a different material may be utilized to increase the heat dissipation efficiency. Alternatively, the irregularities may be configured for additional informational purposes rather than to increase the heat dissipation efficiency.

The thickness of the light path adjuster may be less than or equal to the thickness of the substrate. For example, the ratio of the thickness of the light path adjuster and the thickness of the substrate may be within a range from 1:1 to 1:1.4.

The light emitting device may further include an integrated circuit (IC) configured to control the light emitter, and the light path adjuster may extend from one surface of the light emitter to cover a top surface of the IC.

The light emitting device may further include a cover layer arranged at an upper end of the light emitter and at a lower end of the light transmitter.

Specifically, the cover layer may have a refractive index less than the refractive index of the light transmitter.

In this case, the cover layer and the light path adjuster may include at least one common element.

In another embodiment of the present disclosure, the light emitting device may further include a lower light extraction layer at a lower end of the light emitter and at an upper end of the electrode pattern.

The lower light extraction layer may include a material having a refractive index less than a refractive index of the light emitter.

The lower light extraction layer and the light extraction layer may include at least one element in common.

According to another embodiment of the present disclosure, the light emitting device may further include a substrate, and an electrode pattern disposed on the substrate. The additional components may correspond to a PCB. In this case, the light emitter may be disposed on the heat dissipater and connected to the electrode pattern via wiring disposed at the top of the light emitter.

The heat dissipater may be disposed to surround the substrate, thereby increasing heat dissipation efficiency.

According to another embodiment of the present disclosure, the light emitting device may include a light emitter, a cover layer disposed on top of the light emitter, a light transmitter disposed on a top surface of the cover layer and configured to change a characteristic of light emitted from the light emitter; and a light extraction layer disposed on a top surface of the light transmitter.

In this case, the cover layer may be formed to have a refractive index less than the refractive index of the light transmitter.

Further, the cover layer may be formed to have the same refractive index as the light emitter, and may be composed of the same material (e.g., SiO2) for manufacturing convenience.

The light emitting device(s) as described above may be included and utilized in various vehicle lamps, such as main lamps and combination lamps. The light emitting device(s) described above may be employed not only in vehicle lamps but also in various lighting applications, such as spotlights and flashlights, where straightness/heat treatment efficiency is required.

According to another embodiment of the present disclosure, provided is a light emitting module including a circuit board including a conductive pattern for electrical connection, a heat dissipater physically connected to the circuit board, and a light emitting device electrically connected to the circuit board, the light emitting device including a substrate, and an electrode pattern disposed on the substrate, a light emitter disposed on the electrode pattern, a light transmitter disposed on a first region corresponding to at least a portion of a top surface of the light emitter and configured to change a characteristic of light emitted from the light emitter, a light extraction layer disposed on a top surface of the light transmitter, and a light path adjuster arranged to surround a periphery of the light emitter and configured to correct a light path of the light emitter, wherein the light extraction layer may include the same material as the light path adjuster.

The light path adjuster may include regions of different heights.

The light emitting module of claim 10, wherein a ratio of a thickness of the light path adjuster and a thickness of the substrate may be within a range from 1:1 to 1:1.4.

The light emitting device may further include a sub-element disposed on the substrate. The sub-element may be disposed on one side of the light emitter and spaced apart from the light emitter, and the light path adjuster may cover a top surface of the sub-element.

The circuit board may be disposed spaced apart from the light emitting device, wherein an exposure region may be formed between the circuit board and the light emitting device to allow at least a portion of the heat dissipater to be exposed through the exposure region.

The conductive pattern may be disposed above the exposure region for the heat dissipater, wherein an air passage may be formed between the conductive pattern and the exposure region for the heat dissipater.

According to another embodiment of the present disclosure, provided is a lighting apparatus including a circuit board including a conductive pattern for electrical connection, a light emitting device electrically connected to the circuit board, a control device configured to control driving of the light emitting device, and a base cover disposed on the light emitting device and allowing light generated by the light emitting device to be transmitted therethrough, wherein the light emitting device may include a substrate, an electrode pattern disposed on the substrate, a light emitter disposed on of the electrode pattern, a cover layer disposed on the light emitter, a light transmitter disposed on the cover layer, a light extraction layer disposed on the light transmitter, and a light path adjuster arranged at a position surrounding the light emitter and configured to correct a light path of the light emitter, wherein the cover layer and the light extraction layer may include a material having a same refractive index, wherein a refractive index of the material may be less than a refractive index of the light transmitter.

The light extraction layer may include at least one same element as the light transmitter.

The base cover and the light emitting device may be disposed spaced apart from each other to form a gap therebetween, wherein the gap may be filled with a material having a refractive index.

The lighting apparatus may further include a lower light extraction layer arranged between the light emitter and the electrode pattern, wherein the lower light extraction layer may include a material having a refractive index less than a refractive index of the light emitter.

A vertical thickness of the light extraction layer may be within a range from 0.05% to 5% of a vertical thickness of the light transmitter.

According to embodiments of the present disclosure as described above, a light extraction rate of light emitted by a light emitting device may be efficiently improved.

In a specific embodiment, a light extraction layer configured to sequentially change the refractive index may be further disposed on top of the light transmitter, and the refractive index of the light extraction layer may be configured to meet the requirements as described above. Accordingly, the total reflection of light from the light emitting device may be minimized as the light ultimately enters the air.

Further, in one embodiment, heat dissipaters may be efficiently disposed, thereby increasing the efficiency of heat dissipation.

In addition, the material of each component of the light emitting device may be specified, thereby securing stability between components and improving light straightness.

The effects that can be achieved with the present disclosure are not limited to those mentioned above, and other effects not mentioned will become apparent to one of ordinary skill in the art to which the present disclosure belongs from the following description.

### BRIEF DESCRIPTION OF THE DRAWINGS

The accompanying drawings, which are included to provide a further understanding of the invention, illustrate embodiments of the invention and together with the description serve to explain the principle of the invention. In the drawings:
FIGS. 1 and 2 are views illustrating the structure of a light emitting device according to embodiments of the present disclosure;
FIGS. 3 and 4 are top views of a light emitting device according to one embodiment of the present disclosure;
FIG. 5 is a view illustrating a structure for enhancing the heat dissipation efficiency of a light emitting device according to one embodiment of the present disclosure;
FIG. 6 is a view illustrating an internal structure of the light emitting device according to the embodiment shown in FIG. 5;
FIG. 7 is a view illustrating a light emitting device according to another embodiment of the present disclosure;
FIG. 8 is a view illustrating a light emitting device further including a lower light extraction layer according to one embodiment of the present disclosure;
FIGS. 9 and 10 are views illustrating methods of forming a light path adjuster according to various embodiments of the present disclosure;
FIG. 11 is a view illustrating an example of a light emitting device according to one embodiment of the present disclosure being applied to a vehicle lamp;
FIG. 12 is a view illustrating an example of a light emitting device according to one embodiment of the present disclosure being applied to a spotlight; and
FIG. 13 is a view illustrating an example of a light emitting device according to one embodiment of the present disclosure being applied to a flashlight.

### DETAILED DESCRIPTION

In the following description, for the purposes of explanation, numerous specific details are set forth in order to provide thorough understanding of various exemplary embodiments or implementations of the present disclosure. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, or Z" and "at least one selected from the group consisting of X, Y, or Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," or the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), or the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, or the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

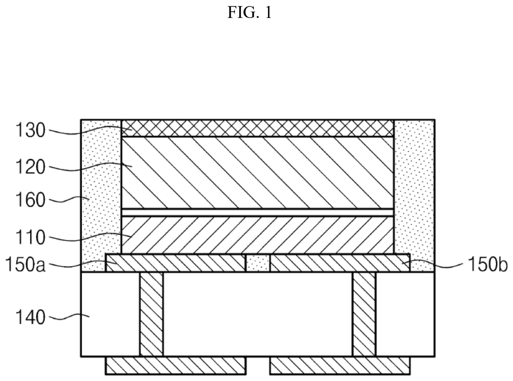

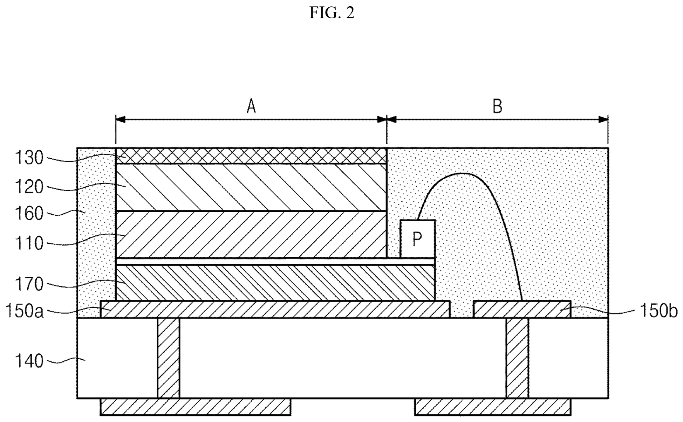

FIGS. 1 and 2 are views illustrating the structure of a light emitting device according to embodiments of the present disclosure.

As shown in FIGS. 1 and 2, a light emitting device according to embodiments of the present disclosure includes a light emitter 110, and a light transmitter 120 disposed on a first region A corresponding to at least a portion of a top surface of the light emitter 110 to change the characteristics of light emitted from the light emitter 110.

The light emitter 110 may be, but need not be limited to, a light emitting diode, and various other types of elements may be utilized that provide a predetermined level or higher level of light straightness suitable for the automotive lamp or lighting apparatus described above. As an example, it is assumed that this embodiment employs a nitride semiconductor or a phosphide semiconductor as the light emitter 110.

The light transmitter 120 is formed of a light transmitting material including a fluorescent material. For example, it may be formed of a ceramic material such as a phosphor ceramic (PC) material that converts the wavelength of light, or a glass material, a silicon material, an epoxy material, or a polymer material, but it is not necessarily limited thereto. Various light transmitters may be used, as long as they change the characteristics of light emitted by the light emitter 110 and satisfy the refractive index requirements described below.

In order to improve the light extraction efficiency, this embodiment proposes a structure in which a light extraction layer 130 is additionally disposed on the top surface of the above-described light transmitter 120, wherein the light extraction layer 130 has a third refractive index n3 in a range between a first refractive index n1 corresponding to the refractive index of air and a second refractive index n2 corresponding to the refractive index of the light transmitter 120.

As the light emitted by the light emitter 110 passes through the above-described light transmitter 120 and enters the air, the refractive index decreases. In the conventional technology that does not include the light extraction layer 130, particularly when the difference between the refractive index n2 of the light transmitter 120 and the refractive index n1 of the air is large, the critical angle may become small, and accordingly the light extraction efficiency may decrease.

In this embodiment, in order to solve the above-mentioned problem, it is proposed that light extraction layer 130 be further disposed as shown in FIGS. 1 and 2, and that the refractive index n3 of the light extraction layer 130 be set between the refractive index n1 of the air and the refractive index n2 of the light transmitter 120 to increase the light extraction efficiency. In other words, the refractive index n2 of the light transmitter 120, the refractive index n3 of the light extraction layer 130, and the refractive index n1 of the air may be set to decrease sequentially, thereby reducing the probability of total reflection.

Preferably, it is proposed that the difference between the refractive index n3 of the light extraction layer 130 and the refractive index n1 of the air be set to be greater than the difference between the refractive index n2 of the light transmitter 120 and the refractive index n3 of the light extraction layer 130.

This may mean that the critical angle of the light that ultimately enters the air is set to be larger than the critical angle of the light that enters the other layers inside the light emitting device, thereby minimizing the total reflection of the light that enters the air from the light extraction layer 130. This is because the light entering another layer inside the light emitting device may be finally extracted by a light path adjuster 160 or the like as described below, whereas the total reflection of the light entering the air from the light extraction layer 130 restricts the role of the light path adjuster 160 or the like.

In this embodiment, it is proposed that the vertical thickness of the light extraction layer 130, which is additionally disposed, be set to be less than the vertical thickness of the light transmitter 120 described above. Although the light extraction layer 130 serves to mitigate the change in refractive index and reduce the critical angle at the final entry of light into the air as described above, the vertical thickness of the light extraction layer 130 may increase the rate at which light is absorbed by the light extraction layer 130 when the light extraction layer 130 has a greater vertical thickness. Accordingly, it is proposed that the vertical thickness of the light extraction layer 130 be in the range of 0.05% to 5% of the vertical thickness of the light transmitter 120.

In the above description, "vertical thickness" may refer to a physical thickness. However, in other examples, it may refer to a "length of a light path" rather than a physical thickness. In other words, even when the physical vertical thickness of the light extraction layer 130 is not set to be less than the physical vertical thickness of the light transmitter 120 described above, the length of the light path of the light extraction layer 130 may be set to be less than the length of the light path of the light transmitter 120 in terms of the length of the light path to achieve the technical effect described above.

In this embodiment, it is proposed that the light extraction layer 130, which is additionally disposed, be composed of at least one element identical to that of the light transmitter 120. Thereby, the formation of an interface of the light extraction layer 130 on the light transmitter 120 may be facilitated. As an example, when the light transmitter 120 is composed of Al₂O₃, the light extraction layer 130 may be composed of SiO₂. Alternatively, when the light transmitter 120 is composed of Si, the light extraction layer 130 may be composed of SiO₂.

For example, the materials of the light emitter 110, light transmitter 120, and light extraction layer 130 described above may be configured with reference to the refractive indices given below.

The light emitter 110 may be configured in the form of a light emitting diode. When a semiconductor element employing GaN, InGaN, AlGaN, AlInGaN, or SiC is used, the refractive index may correspond to about 2.5. When AlInGaP is employed, the refractive index may correspond to about 3.3. When GaAs is employed, the refractive index may correspond to about 3.5.

The light transmitter 120 serves to control the frequency component of the light emitted from the light emitter 110, and may have various materials as long as it has a refractive index less than or equal to the refractive index of the light emitter 110 described above. Organic fluorescent materials include carbonyl compounds having a refractive index of about 1.5 to 1.6, rhodium compounds having a refractive index of about 1.6, and fluorine compounds having a refractive index of about 1.4 to 1.5. As for inorganic fluorescent materials, a zinc oxide material may have a refractive index corresponding to about 2.0, the silicon oxide component may have a refractive index in the range of about 1.5 to 1.6, and the cadmium chloride component may have a refractive index in the range of about 2.0 to 2.1. Additionally, when the light transmitter 120 is composed of PC as in the example described above, it may have a refractive index in the range of 1.7 to 1.8.

When the light extraction layer 130 is additionally disposed on top of the light transmitter 120 according to this embodiment, it may be formed of a material whose refractive index is less than or equal to the refractive index of the light transmitter 120. In this embodiment, it is proposed that the light extraction layer 130 be formed of a material that includes at least one common element with the light transmitter 120 and the difference in refractive index between the light extraction layer 130 and the air be greater than the difference in refractive index between the light transmitter 120 and the light extraction layer 130.

In the case where the light transmitter 120 is composed of PC, the light extraction layer 130 may include oxygen as a common element, and may be composed of, for example, SiO₂. Alternatively, in the case where the light transmitter 120 is composed of Si, the light extraction layer 130 may include Si as a common element, and may be composed of, for example, SiO₂.

However, in this embodiment, the material of the light extraction layer 130 need not be limited to SiO₂, and it is not necessary to exclude the use of other materials as long as the conditions for the refractive index described above are satisfied.

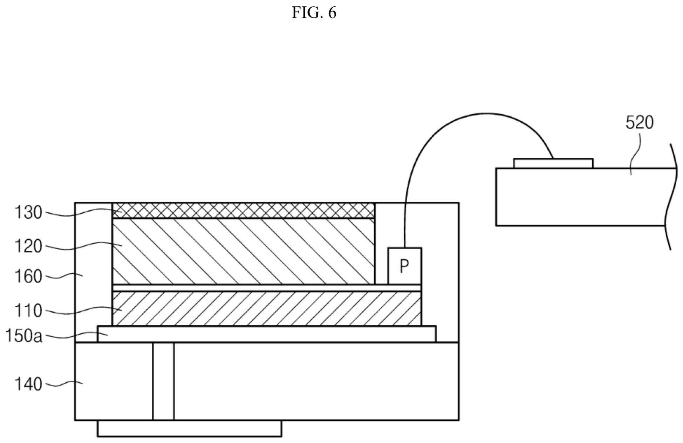

The light emitting device according to the embodiments illustrated in FIGS. 1 and 2 may further include a substrate 140, and electrode patterns 150a and 150b disposed on this substrate 140, and the light emitter 110 described above may be disposed on the electrode patterns 150a and 150b. However, as will be discussed later with respect to FIG. 6, the arrangement of the substrates 140 and electrode patterns 150a, 150b may be varied and need not be limited to the structures of FIGS. 1 and 2.

FIG. 2 illustrates an example in which the light emitting device is divided into a first region A corresponding to the light emitter 110 and a second region B other than the first region A, which are arranged side by side, in order to control the light emitter 110 by connecting the electrode pattern 150b to an N electrode 170 disposed at a lower end of the light emitter 110 at a portion labeled P. On the other hand, FIG. 1 illustrates an example in which the light emitter 110 is disposed directly on the electrode and does not require separate wiring.

As shown in FIGS. 1 and 2, the light path adjuster 160 may be formed on a lateral surface of the light emitter 110 or at a location surrounding the light emitter 110 to adjust the light path of the light emitter 110. The light path adjuster 160 may not only serve to secure and protect the light emitter 110 on the substrate 140, but may also serve to reflect light emitted by the light emitter 110 when the light reaches the light path adjuster 160, thereby improving the straightness of the light.

In this case, the above-described substrate 140 may include a first additive, wherein the first additive may include, for example, Y₂O₃ to enhance heat dissipation efficiency.

It is also proposed that the light path adjuster 160 include a second additive, wherein the first additive and the second additive may have different melting points.

Generally, it is efficient to dissipate heat generated by the light emitter 110 to the outside via the substrate 140. Accordingly, it is preferred that the melting point of the first additive is higher than the melting point of the second additive. Such an increase in heat dissipation efficiency may prevent deterioration of the light emitting device due to heat, and consequently contribute to an increase in light extraction efficiency. As an example, the second additive may include, but need not be limited to, SiO₂ and TiO₂.

When the first additive includes Y₂O₃, the melting point of the component may be about 2,425°C. When the second additive includes SiO₂ and TiO₂, the melting point thereof may be configured to be about 1,713°C.

The light extraction layer 130 and the light path adjuster 160 may include at least one common element. Alternatively, at least one of the materials constituting the light path adjuster 160 may include the second additive. The light extraction layer 130 and the second additive in the light path adjuster 160 may include at least one common element. Thus, an increased adhesion may be provided in the interface between the light extraction layer 130 and the light path adjuster 160, which are arranged to surround the lateral or peripheral and upper surfaces of the light transmitter 120, thereby preventing the light transmitter 120 from coming into contact with moisture. The common element of the light extraction layer 130 and the light path adjuster 160 may be at least one of Si, Ti, or O.

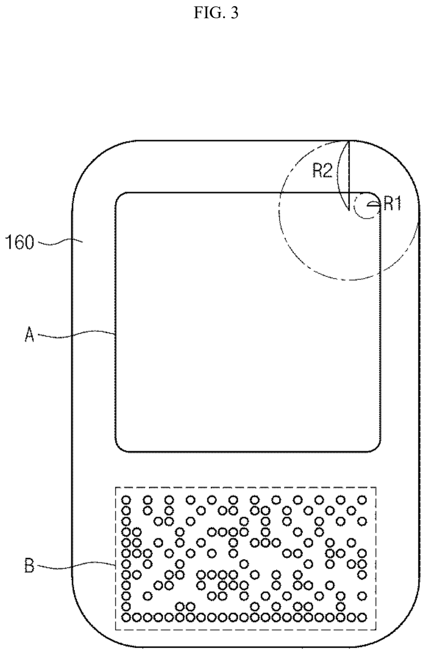

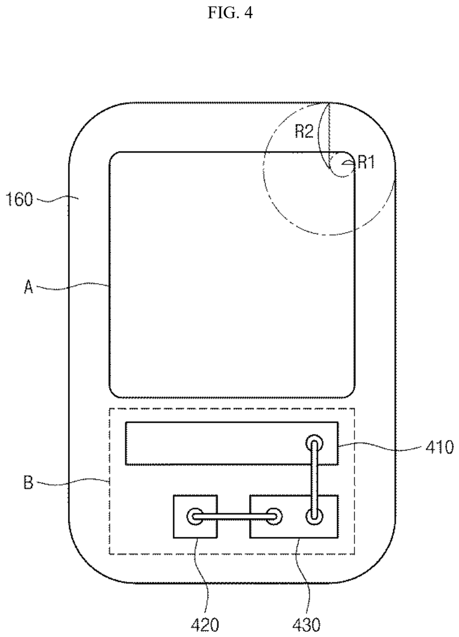

The light transmitter 120 and the light path adjuster 160 may include at least one common element. Alternatively, at least one of the materials constituting the light path adjuster 160 may include the second additive. The light transmitter 120 and the second additive in the light path adjuster 160 may include at least one common element. Thus, an increased adhesion may be provided in the interface between the light transmitter 120 and the light path adjuster 160, thereby blocking a moisture permeation path to the light emitter 110. The common element of the light transmitter 120 and the light path adjuster 160 may be at least one of Si, Ti, or O. FIGS. 3 and 4 are top views of a light emitting device according to one embodiment of the present disclosure.

As described above with reference to FIG. 2, the light emitting device may include the first region A corresponding to the light emitter 110 and from which light is emitted, and the second region B not corresponding to the light emitter 110. In the embodiment shown in FIG. 3, the light path adjuster 160 is exemplarily shown to include a modified region having irregularities in the second region B other than the first region A corresponding to the light emitter 110. The second region B may be a region that is vertically spaced apart from the light emitter 110 so as not to overlap the same.

In FIG. 3, the modified region B may be configured to contain information about the corresponding light emitting device, and may be configured to increase surface area through irregularities to increase the efficiency of heat dissipation.

It may advantageous in terms of heat dissipation efficiency that the thickness of the light path adjuster 160 is set to be less than or equal to the thickness of the substrate 140. Preferably, the ratio of the thickness of the light path adjuster 160 and the thickness of the substrate 140 may be set to be 1:1 to 1:1.4.

In addition, the modified region of the light path adjuster 160 may be formed to have a lower light reflectivity than the region other than the modified region of the light path adjuster 160. Thus, the reflection of external light on the light path adjuster 160 may be canceled by the modification region, and the relative light clarity in the first region A may be increased when viewed from the outside.

Furthermore, as shown in FIG. 3, a corner of the first region A from which light corresponding to the light emitter 110 is emitted may be formed to include a first radius of curvature R₁, and a corner of the light path adjuster 160 may be formed to include a second radius of curvature R₂. The radius of curvature R₁ of the light emitting region A may be different from the radius of curvature R₂ of the light path adjuster 160. Alternatively, the radius of curvature R₁ of the light emitting region A may be less than the radius of curvature R₂ of the light path adjuster 160. Light trapping or loss of light may occur at the corners. By forming curvature at the corners, light that has traveled to the corners may be totally reflected and directed to the light transmitter 120. Accordingly, forming such a radius of curvature may improve light extraction efficiency.

In FIG. 4, a sub-element may be disposed along with the light emitter 110. The sub-element may be any type of element electrically connected to the light emitter 110, such as an integrated circuit (IC) or a Zener diode. That is, it is illustrated that ICs or additional/auxiliary diodes (which are referred to as "sub-elements" based on that the light emitting device including the light emitter 110 may be in the form of a diode) 410, 420, and 430 that control the light emitter 110 are provided, and that the light path adjuster 160 is arranged to cover the top surface of these integrated circuits or sub-elements 410, 420, and 430. The sub-elements may be elements that do not contribute to light emission. The light path adjuster 160 may cover the ICs or sub-elements and the light emitter 110 together. Alternatively, the light path adjuster 160 may be formed to extend from one surface of the light emitter 110 toward a position where the ICs or sub-elements are disposed. Preferably, the light path adjuster 160 may cover the top surface and lateral surface of the ICs or sub-elements and the lateral surface of the light emitter 110 together. In other words, the ICs or sub-elements and the light emitter 110 may share the light path adjuster 160. Thus, the interface of the light path adjuster 160 is not formed between the first region A and the second region B, and therefore there may be no gap at the interface of the light path adjuster 160. Accordingly, at least one region may be prevented from delaminating or moisture may be prevented from penetrating and degrading the reliability of the device. The ICs or sub-elements may be electrically connected to the substrate 140 or the light emitter 110 that share the light path adjuster 160, and may control lighting of the light emitter 110 or contribute to improving the reliability of the device. Thus, fine control of lighting of the light emitter 110 of the light emitting device may be achieved.

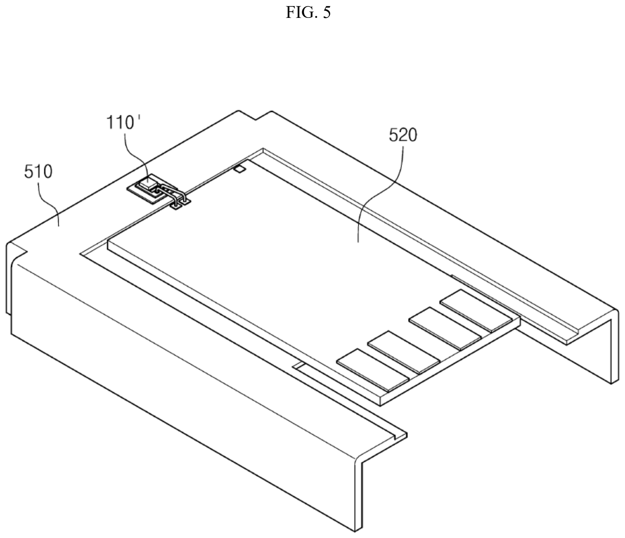

FIG. 5 is a view illustrating a structure for enhancing the heat dissipation efficiency of a light emitting device according to one embodiment of the present disclosure.

For the structure illustrated in FIG. 5, the light emitter 110' is disposed on a heat dissipater 510 and may be physically connected to a printed circuit board (PCB) 520 including a substrate and a pattern of electrodes disposed on the substrate. The light emitter 110' and the PCB may be spaced apart from each other, and may share the heat dissipater 510.

Since the light emitter 110' is disposed on the heat dissipater 510, for example, a heat sink, the heat generated from the light emitter 110' may be efficiently dissipated, thereby minimizing performance degradation caused by heat. As shown in FIG. 5, the heat dissipater 510 may be disposed to surround the periphery of the PCB 520, which is effective in increasing the efficiency of heat dissipation. The region between the light emitter 110' and the PCB 520 may be formed such that at least a portion of the heat dissipater 510 is exposed, and conductive wiring may run over the top of the exposure region. In this case, an air passage may be formed between the conductive wiring and the exposure region of the heat dissipater 510. The conductive wiring may overheat and cause a short, which may be resolved by forming the air passage. The conductive wiring may include a plurality of conductive wires arranged to be spaced apart from each other. Thus, air passages may be formed even in spaced areas between conductive wires. The bottom surface of the PCB 520 may be positioned at a different height than the bottom surface of the light emitter 110'. Preferably, the bottom surface of the PCB 520 may be positioned lower than the bottom surface of the light emitter 110'. Accordingly, the height of the top surface of the PCB 520 may be relatively reduced, thereby reducing the difference in height between the light emitter 110' and the PCB 520, and allowing the conductive wiring to reliably connect the light emitter 110' and the PCB 520, both physically and electrically.

FIG. 6 is a view illustrating an internal structure of the light emitting device according to the embodiment shown in FIG. 5.

The structure of the light emitting device shown in FIG. 6 is basically the same as the structure of the light emitting device shown in FIG. 2, but differs from the structure in FIG. 2 in that the wiring for connecting the electrodes protrudes from the top of the light emitter 110 and connects to the external PCB 520 or the like. Specifically, the above-described wiring may be arranged to extend beyond the position of the light extraction layer 130.

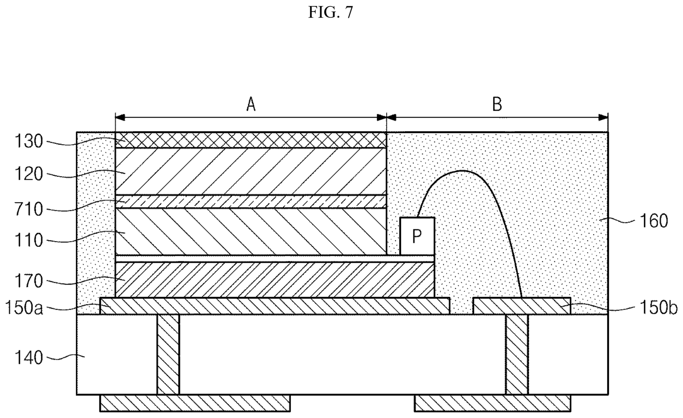

FIG. 7 is a view illustrating a light emitting device according to another embodiment of the present disclosure.

The embodiment illustrated in FIG. 7 differs from the structure of the embodiment of FIG. 2 in that it additionally includes a cover layer 710 formed at the top of the light emitter 110 and the bottom of the light transmitter 120.

In this embodiment, the cover layer 710 may be formed to have a refractive index less than the refractive index n₂ of the light transmitter 120. In this case, total reflection of light may occur between the light emitter 110 and the cover layer 710, which may be adjusted by the light path adjuster 160. However, the angle of incidence of light at the boundary between the cover layer 710 and the light transmitter 120 may be further reduced.

The cover layer 710 may be formed to have the same refractive index as the light extraction layer 130, and may be composed of the same material (e.g., SiO₂) for manufacturing convenience.

The cover layer 710 and the light path adjuster 160 may include at least one common element. Alternatively, at least one of the materials constituting the light path adjuster 160 may include a second additive. The cover layer 710 and the second additive in the light path adjuster 160 may include at least one common element. Thus, an increased adhesion may be provided in the interface between the cover layer 710 and the light path adjuster 160, thereby preventing moisture from penetrating into the light emitter 110. The common element of the cover layer 710 and the light path adjuster 160 may be at least one of Si, Ti, or O.

Additionally, the cover layer 710 and the light extraction layer 130 may include at least one common element. Accordingly, the plurality of components surrounding the light transmitter 120 may include a common element and thus be firmly bonded or formed with each other. In addition, as the light transmitter 120 is surrounded by these components, it may be prevented from being deformed by the external environment or infiltrated by moisture. The common element may be at least one of Si, Ti, or O.

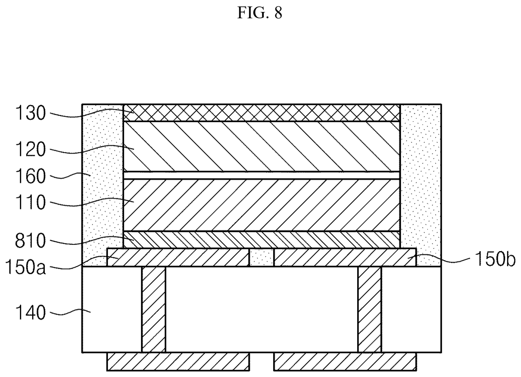

FIG. 8 is a view illustrating a light emitting device further including a lower light extraction layer 810, according to one embodiment of the present disclosure.

Similar to the light emitting device shown in FIG. 1, the light emitting device of FIG. 8 includes a light emitter 110, a light transmitter 120 disposed on at least a portion of a top surface of the light emitter 110 to change the characteristics of light emitted from the light emitter 110, and a light extraction layer 130 disposed on the top surface of the light transmitter 120.

The embodiment shown in FIG. 8 may further include a lower light extraction layer 810 positioned between the bottom of the light emitter 110 and the electrode patterns 150a and 150b.

The light generated by the light emitter 110 includes light that is directly emitted to the outside in a direction toward the light transmitter 120 and the light extraction layer 130 (hereinafter referred to as a "first direction"), but also includes light emitted in a direction toward the electrode patterns 150a and 150b (hereinafter referred to as a "second direction"). In this case, the electrode patterns 150a and 150b may serve to reflect light directed in this second direction and cause the light to be emitted in the first direction again. Increasing the amount of light directed in the second direction that is emitted from the light emitter 110 to the electrode patterns 150a and 150b may increase the amount of light whose path is diverted to the first direction by the electrode patterns 150a and 150b. Thus, by disposing the lower light extraction layer 810 between the light emitter 110 and the electrode patterns 150a and 150b as in the embodiment shown in FIG. 8, the amount of light in the first direction that is emitted from the light emitter 110 and enters the electrode patterns 150a and 150b may be increased, thereby enhancing the light extraction efficiency. In this regard, the lower light extraction layer 810 may employ a material having a lower refractive index than the refractive index of the light emitter 110. Alternatively, the lower light extraction layer 810 may employ the same material as the light extraction layer 130 or the cover layer 710.

The lower light extraction layer 810 and the light extraction layer 130 may include at least one common element. The common element may be at least one of Si, Ti or O. Alternatively, at least one of the materials constituting the light path adjuster 160 may include a second additive, and the lower light extraction layer 810 and the second additive of the light path adjuster 160 may include at least one common element. The common element may be at least one of Si, Ti or O.

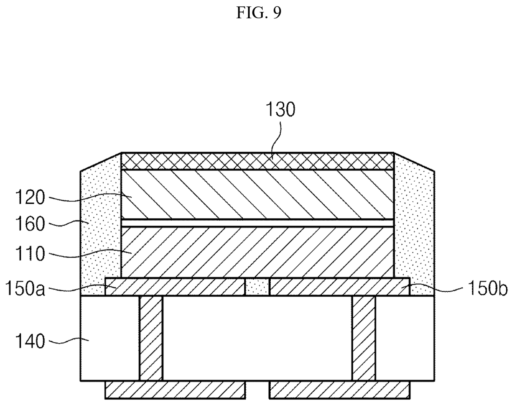

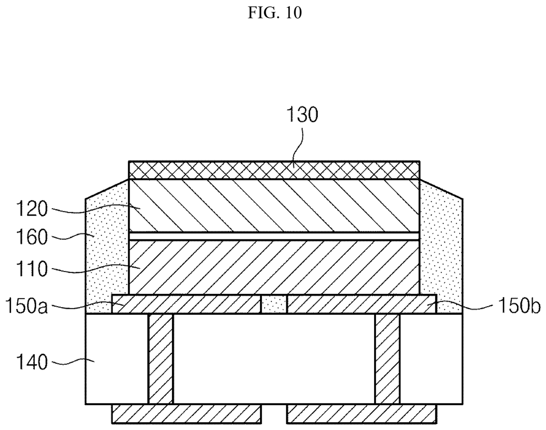

FIGS. 9 and 10 are views illustrating methods of forming a light path adjuster according to various embodiments of the present disclosure.

The structure of FIGS. 9 and 10 is basically the same as the structure of FIG. 1, with a difference in the structure of the light path adjuster 160.

In the embodiment of FIG. 9, the light path adjuster 160 may include a height-varying region. Preferably, the light path adjuster 160 may include a structure that tapers in height from the top boundary of the light extraction layer 130 outwardly. Although not shown, the top surface of the light path adjuster 160 may include a curved shape. When the light path adjuster 160 is formed up to the top boundary of the light extraction layer 130, the straightness of the light may be improved.

In the embodiment of FIG. 10, the light path adjuster 160 tapers outwardly up to the level of the bottom boundary surface of the light extraction layer 130. Thus, the top surface of the light extraction layer 130 may be positioned higher than the top surface of the light path adjuster 160. An upper end of the light path adjuster 160 may be disposed to overlap a lateral surface of the light extraction layer 130 such that it faces a portion of the lateral surface of the light extraction layer 130, and a portion of the lateral surface of the light extraction layer 130 may contact the outside. In particular, the outside that the portion of the light extraction layer 130 contacts may be air. Accordingly, by increasing the area of the light extraction layer 130 that contacts air, which is a material with a lower refractive index, the efficiency of light extraction to the outside may be increased.

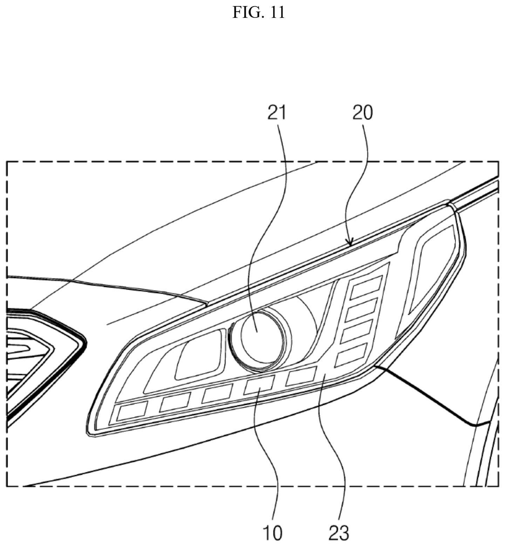

FIGS. 11 to 13 are examples of light emitting devices or lighting apparatuses to which an embodiment of the present disclosure may be applied. The light emitting device may include a control device capable of controlling the light emitter. The device may be a physical control, such as a switch, or may be an electrical control that controls an illumination or a driving signal. The light emitting device may further include a base cover to cover the light emitting device. The base cover may be light transmissive. Thus, light generated by the light emitting device may be emitted to the outside through the base cover. The base cover may include the function of light diffusion. The base cover may block an electrical connection and may be formed of an insulating material. The base cover and the light emitting device may be spaced apart from each other and the gap therebetween may be filled with a material having a refractive index. For example, the gap may be filled with a gas such as air. Alternatively, other types of filling material may fill the gap between the base cover and the light emitting device.

FIG. 11 is a view illustrating an example of a light emitting device according to one embodiment of the present disclosure being applied to a vehicle lamp.

Referring to FIG. 11, the vehicle lamp 20 may include a combination lamp 23 and may further include a main lamp 21. The vehicle lamp 20 may be applied to various parts of a vehicle, such as headlights, backlights, or side mirror lights.

The main lamp 21 may be the main light emitter in the vehicle lamp 20. For example, when the vehicle lamp 20 is utilized as a headlight, it may serve as a headlamp to illuminate the front of the vehicle.

The combination lamp 23 may include light emitting devices 10 and perform two or more functions. For example, when the vehicle lamp 20 is used as a headlight, the combination lamp 23 may perform the functions of a daytime running light (DRL) or a turn signal.

While FIG. 11 illustrates that the combination lamp 23 includes the light emitting device 10, the main lamp 21 may also be configured to employ the light emitting device 10 utilizing a light emitting diode or the like.

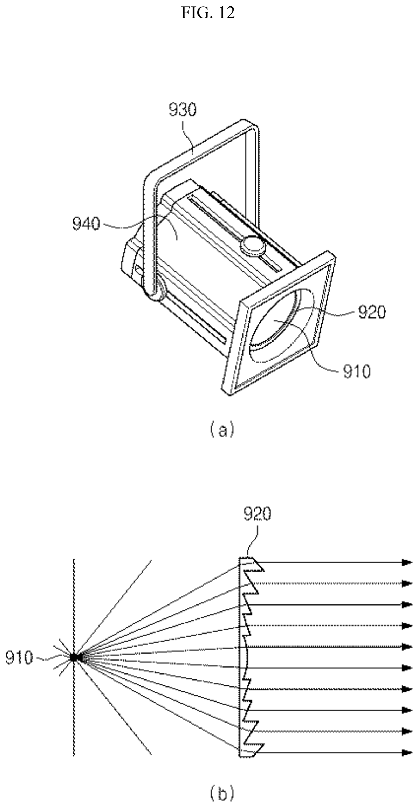

FIG. 12 is a view illustrating an example of a light emitting device according to one embodiment of the present disclosure being applied to a spotlight.

A spotlight used for stage lighting or the like may include a light emitting device 910 and a Fresnel lens 920 for further enhancing light straightness. The Fresnel lens 920 may function to focus light from the light emitting device 910 onto an object to be illuminated, in the form shown in FIG. 12-(b).

When the light emitting device 910 according to the above-described embodiments is applied, light straightness may be improved more efficiently in connection with the Fresnel lens 920.

The spotlight may be provided on a spotlight body 940, as shown in FIG. 12-(a), and may include a fixing means 930 for installation thereof, as needed.

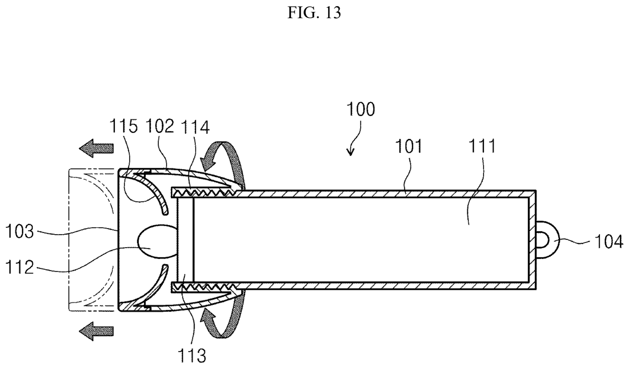

FIG. 13 is a view illustrating an example of a light emitting device according to one embodiment of the present disclosure being applied to a flashlight.

Referring to FIG. 13, a battery receiving space 111 in which a battery is accommodated is formed in a region in the rear portion of the body 101, and a light source is disposed in a region in the front portion of the body 101. The light source may include a light emitter 112 configured to emit light, and a printed circuit board (PCB) 113 on which the light emitter 112 is mounted and which is configured to drive the light emitter 112 using power supplied from the battery.

Furthermore, a threaded groove 114 may be formed on the exterior of one region of the front portion of the body 101. Then, a focus adjustment part 102 is formed at a front end of the body 101. The focus adjustment part 102 is fastened to the groove 114 formed on the exterior of the front portion of the body 101 to adjust the focus by moving forward and backward along the groove 114. The groove 114 may be formed to prevent the focus adjustment portion 102 from being separated and falling out.

Also, a reflector 115 may be formed on the inner side of the focus adjustment part 102 to reflect the light emitted from the light emitter 112 at a predetermined angle. Here, the reflector 115 is formed using a silver-plated plastic plate, aluminum, or the like. In addition, a light transmitting plate 103 formed in front of the focusing element 102 is formed of plastic, glass, or the like. In particular, it may employ a convex lens to diffuse the emitted light forward.

In such a structure, the light transmitting plate 103 may be interpreted as corresponding to the light transmitter as described in the above embodiment. In this case, a light extraction layer (not shown) may be further disposed at the front end of the light emitting plate 103. The light extraction layer (not shown) may be formed to have a refractive index in a range between the refractive index of the light emitting plate 103 and the refractive index of air.

Preferred embodiments of the present disclosure have been described in detail above to allow those skilled in the art to implement and practice the present disclosure. Although the preferred embodiments of the present disclosure have been described above, those skilled in the art will appreciate that various modifications and variations may be made in the present disclosure without departing from the spirit or scope of the disclosure. For example, those skilled in the art may use a combination of elements set forth in the above-described embodiments.

Thus, the present disclosure is not intended to be limited to the embodiments described herein, but is intended to have the widest scope corresponding to the principles and novel features disclosed herein.

The light emitting device according to embodiments of the present disclosure as described above, and a vehicle lamp including the same may be applied to various vehicle lamps, such as main lamps and combination lamps, and may be employed not only in vehicle lamps but also in various lighting applications, such as spotlights and flashlights, where straightness/heat treatment efficiency is required.

## Claims

1. A light emitting device comprising:
a light emitter;
a light transmitter disposed on a first region corresponding to at least a portion of a top surface of the light emitter and configured to change a characteristic of light emitted from the light emitter; and
a light extraction layer disposed on a top surface of the light transmitter,
wherein, a refractive index of air corresponds to a first refractive index, a refractive index of the light transmitter corresponds to a second refractive index, and the light extraction layer has a third refractive index in a range between the first refractive index and the second refractive index.

2. The light emitting device of claim 1, wherein a difference between the third refractive index and the first refractive index is set to be greater than a difference between the second refractive index and the third refractive index.

3. The light emitting device of claim 1, wherein a vertical thickness of the light extraction layer is within a range from 0.05% to 5% of a vertical thickness of the light transmitter.

4. The light emitting device of claim 1, wherein the light extraction layer comprises at least one same element as the light transmitter.

5. The light emitting device of claim 1, further comprising:
a substrate;
an electrode pattern disposed on the substrate with the light emitter disposed on the electrode pattern; and
a light path adjuster disposed around the light emitter and configured to correct a light path of the light emitter,
wherein the light extraction layer comprises at least one same element as the light transmitter.

6. The light emitting device of claim 1, further comprising:
a cover layer arranged at an upper end of the light emitter and at a lower end of the light transmitter,
wherein the cover layer has a refractive index less than the refractive index of the light transmitter.

7. The light emitting device of claim 6, wherein the cover layer comprises at least one same element as the light extraction layer.

8. The light emitting device of claim 1, further comprising:
a substrate; and
an electrode pattern disposed on the substrate; and
a lower light extraction layer arranged between the light emitter and the electrode pattern,
wherein the lower light extraction layer comprises a material having a refractive index less than a refractive index of the light emitter.

9. The light emitting device of claim 8, wherein the lower light extraction layer and the light extraction layer comprise at least one element in common.

10. A light emitting module comprising:
a circuit board comprising a conductive pattern for electrical connection;
a heat dissipater physically connected to the circuit board; and
a light emitting device electrically connected to the circuit board, the light emitting device including:
a substrate,
an electrode pattern disposed on the substrate,
a light emitter disposed on the electrode pattern,
a light transmitter disposed on a first region corresponding to at least a portion of a top surface of the light emitter and configured to change a characteristic of light emitted from the light emitter,
a light extraction layer disposed on a top surface of the light transmitter, and
a light path adjuster arranged to surround a periphery of the light emitter and configured to correct a light path of the light emitter,
wherein the light extraction layer comprises a same material as the light path adjuster.

11. The light emitting module of claim 10, wherein the light path adjuster comprises regions of different heights.

12. The light emitting module of claim 10, wherein a ratio of a thickness of the light path adjuster and a thickness of the substrate is within a range from 1:1 to 1:1.4.

13. The light emitting module of claim 10, wherein the light emitting device further comprises:
a sub-element disposed on the substrate,
wherein the sub-element is disposed on one side of the light emitter and spaced apart from the light emitter, and
wherein the light path adjuster covers a top surface of the sub-element.

14. The light emitting module of claim 10, wherein the circuit board is disposed spaced apart from the light emitting device, and
wherein an exposure region is formed between the circuit board and the light emitting device and is configured to allow at least a portion of the heat dissipater to be exposed through the exposure region.

15. The light emitting module of claim 14, wherein the conductive pattern is disposed above the exposure region for the heat dissipater, and
wherein an air passage is formed between the conductive pattern and the exposure region for the heat dissipater.

16. A lighting apparatus comprising:
a circuit board comprising a conductive pattern for electrical connection;
a light emitting device electrically connected to the circuit board;
a control device configured to control driving of the light emitting device; and
a base cover disposed on the light emitting device and allowing light generated by the light emitting device to be transmitted therethrough,
wherein the light emitting device includes:
a substrate,
an electrode pattern disposed on the substrate,
a light emitter disposed on of the electrode pattern,
a cover layer disposed on the light emitter,
a light transmitter disposed on the cover layer,
a light extraction layer disposed on the light transmitter, and
a light path adjuster arranged at a position surrounding the light emitter and configured to correct a light path of the light emitter,
wherein the cover layer and the light extraction layer comprise a material having a same refractive index, wherein a refractive index of the material is less than a refractive index of the light transmitter.

17. The lighting apparatus of claim 16, wherein the light extraction layer comprises at least one same element as the light transmitter.

18. The lighting apparatus of claim 16, wherein the base cover and the light emitting device are disposed spaced apart from each other to form a gap therebetween, and
wherein the gap is filled with a material having a refractive index.

19. The lighting apparatus of claim 16, further comprising:
a lower light extraction layer arranged between the light emitter and the electrode pattern,
wherein the lower light extraction layer comprises a material having a refractive index less than a refractive index of the light emitter.

20. The lighting apparatus of claim 16, wherein a vertical thickness of the light extraction layer is within a range from 0.05% to 5% of a vertical thickness of the light transmitter.
